# EUROPEAN PATENT APPLICATION

(11) **EP 4 424 888 A1**
(43) Date of publication of application: **04.09.2024**
(21) Application number: 22886382.5
(22) Date of filing: 23.06.2022
(51) Int. Cl.: C30B 25/18, C04B 35/581, C04B 41/87, C30B 29/38, H01L 21/20

(54) **SEED SUBSTRATE FOR EPITAXIAL GROWTH AND METHOD FOR PRODUCING SAME, AND SEMICONDUCTOR SUBSTRATE AND METHOD FOR PRODUCING SAME**

(30) Priority: 27.10.2021 JP 2021175901
(71) Applicant: SHIN-ETSU CHEMICAL CO., LTD., Tokyo 1000005 (JP)
(72) Inventor: KUBOTA Yoshihiro, Annaka-shi, Gunma 379-0195 (JP); KONISHI Shigeru, Annaka-shi, Gunma 379-0195 (JP); MOGI Hiroshi, Annaka-shi, Gunma 379-0224 (JP); HIGUCHI Koichi, Annaka-shi, Gunma 379-0224 (JP)
(74) Representative: Vossius & Partner Patentanwälte Rechtsanwälte mbB
(86) International application number: PCT/JP2022/025123
(87) International publication number: WO 2023/074045

(57) **Abstract**

The present invention relates to obtaining high-quality, inexpensive seed substrates with few crystal defects for epitaxial growth of epitaxial substrates and solid substrates of group III nitrides such as AlN, AlₓGa₁₋ₓN (0<X<1) and GaN, and manufacturing method thereof.

The seed substrate for epitaxial growth of the present invention has a support substrate, a planarizing layer of 0.5 to 3 µm provided on the top surface of the support substrate, and a seed crystal layer provided on the top surface of the planarizing layer. The support substrate includes a core of group III nitride polycrystalline ceramics and a 0.05 to 1.5 um encapsulating layer that encapsulates the core having surface voids filled and flattened by Al or Si oxide, nitride, oxynitride, or a mixture thereof. The seed crystal layer is provided by thin-film transfer of 0.1 to 1.5 um of the surface layer of Si <111> single crystal with oxidation-induced stacking faults (OSF) of less than 10 defects/cm².

## Description

### TECHNICAL FIELD

The present invention relates to seed substrates used for epitaxial growth of epitaxial substrates and solid substrates of group III nitrides with few surface defects and excellent characteristics, such as aluminum nitride (AlN), aluminum gallium nitride (AlₓGa₁₋ₓN (0<x<1)), and gallium nitride (GaN), and manufacturing method thereof. More specifically, it relates to seed substrates for epitaxial growth of epitaxial substrates and solid substrates of group III nitrides such as AlN, Al_{c}Ga₁₋ₓN(0<X<1) and GaN-based materials with extremely low crystal defects, warpage and voids, and high quality and low cost, and manufacturing method thereof.

### BACKGROUND ART

Group III nitride crystal substrates such as AlN-and GaN-based substrates have a wide band gap and excellent high-frequency characteristics with short wavelength luminescence and high breakdown voltage. Therefore, group III nitride substrates are expected to be applied to devices such as light-emitting diodes (LEDs), lasers, Schottky diodes, power devices, and high-frequency devices. For example, with regard to AlN-based crystal substrates, the recent outbreak of coronavirus and other viruses has triggered a growing demand for AlN and/or AlₓGa₁₋ₓN (0.5<X<1) single crystals for light emitting diodes, especially in the deep ultraviolet region (UVC; 200-280 nm), for the purpose of bacterial and virus elimination. However, at present, these single-crystal substrates of AlN and/or AlₓGa₁₋ₓN (0.5<X<1) have many surface defects, are of low quality and high cost, and do not have the expected characteristics when various devices are made. Hence, the wide spread of these substrates and the expansion of their applications are limited. On the other hand, GaN-based crystal substrates are required to have higher high-frequency characteristics and greater breakdown voltage performance with the start of 5G communications and the shift to EVs in automobiles. As a result, GaN-based crystal substrates with very few crystal defects and low-cost epitaxial substrates and solid substrates are also in demand. However, as with AlN-based substrates, GaN-based substrates also have many crystal surface defects and are of low quality, but their prices are high. Therefore, the widespread use of GaN-based substrates for the aforementioned devices has been prevented, and further improvement is desired.

For example, as described in Non-Patent Document 1 and Non-Patent Document 2, AlN single-crystal substrates are difficult to manufacture by the melt method commonly used for silicon (Si) single-crystals, etc. because AlN has no melting point. So they are usually manufactured by the sublimation method (modified Raleigh method) using silicon carbide (SiC) or AlN as seed crystals at 1700 to 2250°C under N₂ atmosphere. Alternatively, they are made by the hydride vapor phase epitaxy (HVPE) on sapphire substrates or AlN substrates obtained by the sublimation method, as disclosed in Patent Document 1 and Non-Patent Document 3. Since AlN single crystals manufactured by the sublimation method require high temperatures for crystal growth, only small-diameter substrates of 2 to 4 inches in diameter can be obtained at present due to equipment limitations, and they are extremely expensive. The dislocation density of the resulting AlN single crystals is relatively low, smaller than 10⁵ cm⁻², but on the other hand, the crystals are colored by carbon and metallic impurities derived from charcoal materials such as crucibles and insulation materials, and have the disadvantages of low resistivity and low UV transmission. On the other hand, AlN single crystals made by hydride vapor phase epitaxy (HVPE) on sapphire substrates are relatively inexpensive and have little coloration, but the difference in lattice constants between AlN and sapphire results in high dislocation density and low resistivity of the AlN crystal. AlN crystals obtained by HVPE deposition on sublimation method AlN substrates have relatively low dislocation density, but are opaque to deep UV emission and have low resistivity due to colorant contamination from the underlying substrate AlN. In addition, conventionally, the expensive sublimation method AlN crystals are used as the base substrate that also serves as seed crystals, which has the disadvantage of being extremely costly.

As for GaN substrates, bulk GaN substrates made by growing GaN crystals in liquid ammonia or Na flux have relatively few defects and are of high quality, but they are extremely expensive because they require high-temperature, high-pressure equipment. In addition, it is extremely costly because it is used as a base substrate that also serves as a seed crystal, as is the case with the AlN substrate of the sublimation method described above. On the other hand, if heteroepitaxial growth is performed on sapphire and other substrates using the MOCVD or hydride vapor deposition (HVPE or THVPE), which grow crystals in the vapor phase, it is possible in principle to achieve higher crystal quality and larger size. In practice, however, the lattice constants and thermal expansion coefficients between the generated GaN crystals and the underlying sapphire substrate differ greatly, resulting in numerous crystal defects and cracks during production, and high-quality crystals cannot be obtained.

As one of the solutions to these problems, Patent Document 2 discloses a so-called QST (product name) substrate having a support substrate with an AlN ceramic core and an encapsulating layer that encapsulates the AlN ceramic core with a SiO₂/P-Si/SiO₂/Si₃N₄ multilayer film, a planarizing layer such as SiO₂ on the top surface of the support substrate, and a seed crystal layer with Si<111> thin film transferred as a seed crystal on the top surface of the planarizing layer.

However, since this method uses polycrystalline ceramics for the core, there are voids on the ceramic surface due to solvent volatilization marks, polishing scratches, and polycrystalline degranulation marks that inevitably occur during its manufacturing process. During thin film transfer of seed crystals, seed crystals are not transferred well at the locations where these voids are present, causing crystal defects in the subsequent epitaxially grown film. In addition, when this polycrystalline ceramic is used as the core, it is likely to cause thermal expansion coefficient differences between layers of the multilayer film that encapsulates the core, or between the encapsulating layer, seed crystal layer, and seed crystal layer. In addition, thermal stress based on the difference in thermal expansion coefficient causes cracks, chips, or distortion between the encapsulating layer, planarizing layer, or seed crystal layer, or between each layer formed in the epitaxial deposition process in subsequent processes, etc. As a result, it was found that defects in the seed crystal due to the above-mentioned voids, contamination due to impurity diffusion in the AlN ceramic core, and various strains also adversely affect the seed crystal, causing various defects in the subsequent epitaxial growth and resulting in poor characteristics epitaxially grown film.

Therefore, it is difficult to obtain, for example, AlN and/or AlₓGa₁₋ₓN (0<X<1) substrates for light-emitting diodes used in the ultra-short wavelength deep ultraviolet region (UVC; 200-280 nm), which require low crystal defects, especially low crystal surface defects, and excellent characteristics, or GaN crystal substrates suitable for high frequency and high breakdown voltage for 5G communications and EVs, etc. with low crystal defects, high quality and at a low cost, and new solutions have been desired.

### PRIOR ART DOCUMENTS

### PATENT DOCUMENTS

Patent Document 1: JP6042545B
Patent Document 2: JP6626607B
Patent Document 3: JP2936916B

### NON-PATENT DOCUMENTS

Non-Patent Document 1: Japanese Journal of Applied Physics; Vol.46, No.17,2007, pp.L389-L391
Non-Patent Document 2: SEI Technical Review; No. 177, pp. 88-91
Non-Patent Document 3: Fujikura Technical Review; No. 119, 2010, Vol. 2, pp. 33-38
Non-Patent Document 4: LEDs Magazine Japan; December 2016, pp. 30-31

### SUMMARY OF THE INVENTION

### PROBLEMS TO BE SOLVED BY THE INVENTION

The inventors have, therefore, studied various ways to solve the above problems and, as a result, have arrived at the present invention. That is, the present invention is a seed substrate for epitaxial growth with few defects, especially surface defects, and its manufacturing method as follows: (1) After the surface voids of a polycrystalline ceramic core are filled and flattened by Al or Si oxide, nitride, oxynitride, or a mixture thereof, (2) said core is encapsulated with a 0.05 to 1.5 um encapsulating layer, followed by (3) thin film transfer of a 0.1 to 1.5 um surface layer of Si <111> single crystal as a seed crystal layer, and if necessary (4) a stress-adjusting layer on the bottom layer.

Although the role of seed crystal in the above-mentioned substrate has been partly understood, the causal relationship between characteristics of the Si<111> seed crystal at the time of transfer and the subsequent epitaxial deposition has not been fully understood. The inventors conducted many experiments and found that (1) if surface voids exist in the polycrystalline ceramic substrate that serves as the core, even if an encapsulating layer or a planarizing layer is interposed between the ceramic substrate and the seed crystal layer, the effects of the voids cannot be completely removed, and some of the surface voids also affect the transferred seed crystal, causing defects; (2) there is a significant causal relationship between the original characteristics of the seed crystal Si<111> and defects in the epitaxial film, and (3) distortion caused by thermal stress differences between the layers and contamination from the core affect the Si<111> seed crystal and increase defects in the epitaxially deposited film.

Based on these experimental results, in order to obtain seed substrates for epitaxial growth of group III nitrides such as AlN, AlₓGa₁₋ₓN (0<X<1), GaN, etc. with few defects, excellent characteristics, and low cost, the inventors have found that by reducing surface voids in the polycrystalline ceramic core as described above, reducing thermal stress by optimizing the thickness and quality of the encapsulating layer, planarizing layer, and seed crystal layer, and by reducing the oxidation-induced stacking fault (OSF) of the seed crystal Si<111> (as described in Patent Document 3) to 10 defects/cm² or less in addition to strain and contamination, the thin film transfer of 0.1 to 1.5 µm thickness is extremely good, and the subsequent epitaxial film shows suitable results.

The number of oxidation-induced stacking faults (OSF) (defects/cm2) was measured by the evaluation method of Patent Document 3.

### MEANS FOR SOLVING THE PROBLEMS

In order to achieve the above-mentioned purpose, a seed substrate for epitaxial growth of the present invention has a support substrate, a planarizing layer of 0.5 to 3 um provided on the top surface of the support substrate, and a seed crystal layer provided on the top surface of the planarizing layer. The support substrate includes a core of group III polycrystalline nitride with surface voids filled and flattened by Al or Si oxide, nitride, oxynitride, or a mixture of these, and an encapsulating layer of 0.05 to 1.5 um that encapsulates the core. The seed crystal layer is provided by thin-film transfer of 0.1 to 1.5 um of the surface layer of Si <111> single crystal.

In the present invention, the group III nitride polycrystalline ceramics forming the core may be AlN ceramics.

In the present invention, the encapsulating layer may include at least a layer of Si₃N₄.

In the present invention, the planarizing layer may be made of SiO₂ and/or silicon oxynitride (SiₓO_{y}N_{z}) or AlAs.

In the present invention, Si <111>, which forms the seed crystal layer, may have oxidation-induced stacking faults (OSF) of less than 10 defects/cm²

In the present invention, a stress-adjusting layer may be provided on the bottom surface of the support substrate.

In the present invention, the encapsulating layer may be deposited by the LPCVD.

In the present invention, the planarizing layer may be made of AlAs on one or all sides of the support substrate by either plasma CVD, LPCVD, or low-pressure MOCVD.

In the present invention, the seed crystal layer may be provided by ion implanting hydrogen and/or He into Si <111> single crystals, followed by transferring a 0.1 to 1.5 um thin film by physical means at 450°C or lower.

In the present invention, the stress-adjusting layer is formed of a material selected from SiO₂, Si₃N₄, amorphous Si, polycrystalline Si, etc. or a combination of these materials with a thermal expansion coefficient that can be corrected according to the state of warpage after the planarizing layer is provided. However, when even the compatibility with electrostatic chucks is considered, the bottom layer of the support substrate is suitable to be at least polycrystalline Si prepared by a method chosen from sputtering, plasma CVD, or LPCVD, or a polycrystalline Si layer with SiO₂ and/or silicon oxynitride (SiₓO_{y}N_{z}) interposed that has an affinity with the encapsulating layer. When polycrystalline Si film is used for both stress adjustment and electrostatic chucking, polycrystalline Si itself or amorphous Si that has been polycrystallized by heating or lasers, etc., may be used. The reason for placing the polycrystalline Si film at the bottom layer is that the electrostatic chucking force is stronger, the higher the conductivity of the film and the shorter the distance.

The semiconductor substrate of an embodiment of the present invention is characterized in that a III-V semiconductor thin film is deposited on the top surface of a seed substrate for epitaxial growth of either of the above. The III-V semiconductor thin film may be a nitride semiconductor thin film containing Ga and/or Al.

A manufacturing method of a substrate for epitaxial growth in accordance with the embodiment of the present invention comprises steps of: preparing a core consisting of group III nitride polycrystalline ceramics with surface voids filled and flattened by Al or Si oxide, nitride, oxynitride, or mixture of these; obtaining a support substrate by depositing an encapsulating layer so as to wrap the core, the encapsulating layer having a thickness of between 0.05 µm and 1.5 µm, inclusive; depositing a planarizing layer on an upper surface of the support substrate, the planarizing layer having a thickness of between 0.5 um and 3.0 µm, inclusive; and providing a seed crystal layer by thin-film transfer of 0.1 to 1.5 µm of the surface layer of Si <111> single crystal on the top surface of the planarizing layer.

In the present invention, the seed crystal layer may be provided by thin-film transfer of 0.1 to 1.5 µm of the surface layer of Si <111> single crystal with oxidation-induced stacking fault (OSF) of 10 defects/cm² or less on the top surface of the planarizing layer.

In the present invention, the encapsulating layer may be deposited by the LPCVD.

In the present invention, the planarizing layer may be made of SiO₂ and/or silicon oxynitride (SiₓO_{y}N_{z}) or AlAs on one or all sides of the support substrate by either plasma CVD, LPCVD, or low-pressure MOCVD.

In the present invention, the seed crystal layer may be provided by ion implanting hydrogen and/or He into Si <111> single crystals with an OSF of 10 defects/cm² or less, followed by transferring a 0.1 to 1.5 µm thin film by physical means at 450°C or lower.

The present invention may further comprise a step of further providing a stress-adjusting layer on the bottom surface of the support substrate. This stress-adjusting layer may have a thermal expansion coefficient that enables further correction of the warpage after the planarizing layer is provided and may be made of polycrystalline Si prepared by a method selected from at least the sputtering and LPCVD.

The manufacturing method of a semiconductor substrate according to an embodiment of the present invention comprises the steps of: manufacturing a seed substrate for epitaxial growth by any of the above methods; and depositing a III-V semiconductor thin film on the top surface of the seed substrate for epitaxial growth.

### EFFECT OF THE INVENTION

The present invention can provide high-quality and low-cost seed substrates for epitaxial growth of epitaxial substrates and solid substrates of group III nitrides such as AlN and/or AlₓGa₁₋ₓN (0<X<1) substrates for light emitting diodes used in the deep ultraviolet region (UVC; 200-280nm), or GaN crystal substrates suitable for high frequency and high breakdown voltage applications associated with 5G communication and shift to EVs in automobiles, with few defects and at low cost.

### BRIEF DESCRIPTION OF THE DRAWINGS

FIG. 1 is a diagram showing the cross-sectional structure of a seed substrate 1.
FIG. 2 is a diagram showing the procedure for manufacturing the seed substrate 1.

### EMBODIMENTS OF THE INVENTION

The embodiments of the present invention will be described in detail hereinafter, but the present invention is not limited thereto.

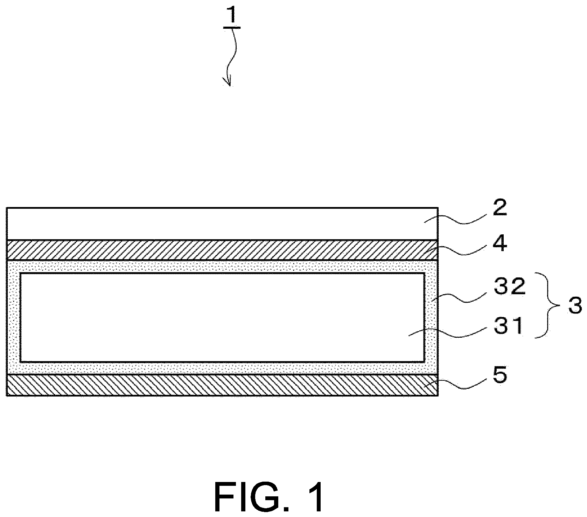

FIG. 1 shows a cross-sectional structure of a seed substrate for epitaxial growth of group III nitrides (hereinafter simply referred to as "seed substrate") 1. The seed substrate 1 shown in FIG. 1 has a structure in which a planarizing layer 4 and a Si <111> seed crystal layer 2 are stacked on a support substrate 3. In addition, if necessary, the stress-adjusting layer 5 is provided on the surface (bottom surface) of the support substrate 3 opposite the surface on which the planarizing layer 4 is stacked.

The support substrate 3 has a core 31 serving as the core material of the support substrate 3, and an encapsulating layer 32 covering the core 31.

The core 31 is formed by group III nitride polycrystalline ceramics. Specifically, AlN, Si₃N₄, GaN, or a mixture of these materials can be used. Polycrystalline AlN ceramics are suitable because they have the lattice constant and thermal expansion coefficient close to those of the target group III nitride crystal, have high thermal conductivity, and are inexpensive. In terms of device processing, wafers with a mirror finish of 200 to 1000 um thickness should be selected, which can be handled in semiconductor production lines. There are various manufacturing methods of AlN ceramics, but because of their productivity and economy, the so-called sheet forming/atmospheric pressure sintering method is commonly used. In the sheet forming/atmospheric pressure sintering method, AlN powder, sintering agent, organic binders, and solvents are mixed to create wafer-like green sheets, which are then degreased, sintered in an N₂ atmosphere, and polished to make products. The sintering agent may be selected from Y₂O₃, Al₂O₃, CaO, and the like, but Y₂O₃ is usually suitable because it exhibits the highest thermal conductivity in the substrate after sintering.

The polycrystalline ceramic substrates obtained by the above process usually have surface voids of several hundred nm to several tens of um in depth due to degreasing marks during sintering and degranulation marks during polishing, even if the product is finished to an average smoothness of several nm. As mentioned above, these voids have a negative impact on the thin film transfer of Si <111> seed crystal, and also easily cause defects in subsequent epitaxial growth. Therefore, in the present invention, the surface voids of these ceramic substrates are filled with Al or Si oxide, nitride, oxynitride, or a mixture of these materials, and then flattened to make a core. More specifically, silicone compounds and/or silicone compounds with at least one of SiO₂, Si₃N₄, or AlN powder are applied to the surface of polycrystalline ceramics and then treated in an N₂ atmosphere to fill surface voids and flatten them before use as a core.

However, if the filled and flattened AlN ceramic is used as the core 31 as it is, metallic impurities in the raw materials AlN and Y₂O₃ powder, as well as carbon, oxygen, and other impurities from insulation materials, furnace materials, containers, etc. during sintering become a source of contamination, causing adverse effects such as crystal defects and coloration in the target single crystal.

For this reason, an encapsulating layer 32 is provided to wrap and encapsulate the filled and flattened polycrystalline ceramic core 31 to protect it from various sources of contamination. When encapsulating the core 31 with the encapsulating layer 32, each layer consisting of the encapsulating layer 32 must be considered in terms of its composition and thickness so that thermal stress is as small as possible and thermal conduction is as large as possible. In the present invention, it is preferable to optimize the total thickness of the encapsulating layer 32 in the range of 0.05 to 1.5 µm from a manufacturing cost standpoint.

The composition of the encapsulating layer 32 can be selected appropriately in consideration of thermal expansion coefficient and thermal conductivity, but to enhance its impurity diffusion prevention ability, it is preferable to cover and encapsulate the entire core at least with a film consisting of silicon nitride (Si₃N₄).

This encapsulating layer 32 may be provided with p-Si as a layer for electrostatic chucking if necessary, for example, if the use of electrostatic chucking is desired. This p-Si layer may be deposited between the AlN ceramics and the Si₃N₄ layer or possibly together with or under the stress-adjusting layer 5 described below. In such cases, if adhesion between p-Si and AlN core and Si₃N₄ is insufficient, a film of SiO₂ or silicon oxynitride (SiₓO_{y}N_{z}) with high adhesion properties may be interposed, taking into account the affinity and thermal expansion coefficient between each layer.

For seed substrates for epitaxial growth of group III nitrides such as GaN for high-frequency applications, especially for very high-frequency applications such as Giga Hz wave or millimeter wave, in order to avoid high-frequency losses in devices, the electrical resistivity (room temperature) of the above Si <111> seed crystal layer 2 is preferably 1 kΩ-cm or more. This is because the Si <111> seed crystal layer 2 with an electrical resistivity (at room temperature) of 1 kQ-cm or less would cause high-frequency losses due to giga Hz wave or millimeter wave, resulting in device heat generation and high power consumption, and would not provide sufficient characteristics.

When a p-Si film is provided for the electrostatic chuck, its resistance should be as high as possible to provide the necessary adsorption force. The p-Si film may be deposited on the lower layer of core 31, as far away as possible from the seed crystal layer 2 on which the epitaxial film is stacked, or on the lower part of the stress-adjusting layer 5 as described below, or may be multi-layered deposited simultaneously with the stress-adjusting layer 5. High-resistance p-Si has low high-frequency loss, and when placed at the bottom of the support substrate 3, it is close to the electrostatic chuck, so even with high resistance, sufficient electrostatic force is available. Therefore, substrate adsorption is possible sufficiently without doping. To further reduce high-frequency losses, it is more desirable to remove the p-Si layer by back-grinding the substrate at the end of device fabrication. When the stress-adjusting layer 5 is provided, it is preferable to maintain the p-Si resistance as high as possible, but the minimum amount of boron (B), phosphorus (P), or other doping necessary to generate the required electrostatic force is not restricted.

In the encapsulating layer 32, if the thickness of each layer becomes too thick, the stress between the layers increases due to the difference in thermal expansion coefficient, causing delamination between the layers. Therefore, even if films of various compositions are selected and combined, it is not desirable for the thickness of the encapsulating layer 32 to be more than 1.5 µm. On the other hand, in terms of the function of sealing impurities, a thickness of 0.05 µm or less is insufficient to prevent the diffusion of impurities. From the above, the thickness of the encapsulating layer 32 is preferably in the range of 0.05 to 1.5 µm. The deposition method for the encapsulating layer can be selected from conventional deposition methods such as MOCVD, atmospheric pressure CVD, LPCVD, sputtering, etc. The LPCVD is particularly preferred because of the film quality, the film coverage, and the impurity diffusion prevention ability.

A planarizing layer 4 of 0.5 to 3 µm is stacked on the encapsulating layer 32 at least on the top surface of the support substrate 3. The planarizing layer 4 is selected from ordinary ceramic film materials such as SiO₂, Al₂O₃, Si₃N₄, SiC, or silicon oxynitride (SiₓO_{y}N_{z}), etc., or Si, GaAs, AlAs, etc., which are often used as sacrificial layers for etching, etc. It is preferable to select SiO₂ and/or silicon oxynitride (SiₓO_{y}N_{z}) or AlAs, which are easy to grind or polish during planarization and easy to separate when obtaining solid substrates.

From a cost standpoint, the planarizing layer 4 is normally stacked only on one side of the encapsulating layer 32, but if the warpage is large, it can be deposited to cover the entire encapsulating layer 32. The role of the planarizing layer 4 is literally to secure a planarized surface to enable thin-film transfer of the seed crystal, and its thickness must be sufficient to fill voids and unevenness in the core 31 and encapsulating layer 32, etc., and to obtain the planarized surface sufficient to enable seed crystal transfer. However, a planarizing layer 4 that is too thick is undesirable because it can cause warping and cracking of the seed substrate 1. Therefore, it is suitable to provide a planarizing layer with a thickness of 0.5 to 3 µm on at least the top surface of the encapsulating layer. This is because if the thickness is less than 0.5 um, it is almost impossible to fill the voids and unevenness in the AlN ceramics core 31 and encapsulating layer 32, and if the thickness is 3 µm or more, warping by the planarizing layer 4 is likely to occur. However, as mentioned above, polycrystalline ceramic substrates usually have numerous surface voids of several hundred nm to several tens of µm in depth. As a solution to the dilemma between the above limitations and the reality of the depth of surface voids, the present invention solves the above problem by first "using as a core a ceramic substrate that has been flattened by filling surface voids with a silicone compound and/or a silicone compound with at least SiO₂, Si₃N₄, or AlN powder added to the surface of polycrystalline ceramics and then treated in an N₂ atmosphere to fill the surface voids. The aforementioned silicone compounds are preferred if they are alkoxysilanes and/or condensates thereof, as they are particularly resistant to void filling and easy to flatten subsequently.

Plasma CVD, LPCVD, or low-pressure MOCVD are suitable for the deposition of the planarizing layer 4 in terms of its required film quality and deposition efficiency. The stacked SiO₂ and/or silicon oxynitride (SiₓO_{y}N_{z}) or AlAs are heat treated for quenching or CMP polished for planarization, depending on the film conditions, to prepare for thin-film transfer of the seed crystal layer 2 described below.

The seed crystal is selected to be a substrate with a crystal structure similar to group III nitrides such as AlN, AlₓGa₁₋ₓN (0<X<1), GaN, etc., which are the subject of the present invention. Therefore, Si<111>, SiC, SCAM, AlN, AlGaN, sapphire, etc. are candidates, but Si<111> is suitable from the viewpoints of ease of large-diameter production, availability of commercial products, and low cost. Among Si<111> crystals, Si<111> single crystals with oxidation-induced stacking faults (OSF) of 10 defects/cm2 or less are particularly suitable, as described above.

This is because when the OSF of Si<111> seed crystal, which is the seed for the next process of epitaxial deposition, is 10 defects/cm² or less, the epitaxially deposited crystal has fewer defects following the seed crystal, resulting in superior device characteristics and high yield, which leads to low cost. On the other hand, when the OSF exceeds 10 defects/cm², defects in the epitaxially deposited crystal increase greatly, resulting in poor device characteristics, which inevitably worsen yield and lead to high costs.

When the epitaxial substrates and solid substrates obtained by epitaxial deposition on the seed substrates 1 are used for high-frequency devices, especially for 5G and beyond, it is preferable to select Si <111> seed crystals with an electrical resistivity (room temperature) of 1 kQ-cm or higher. This is because if the electrical resistivity (at room temperature) of the Si <111> seed crystal is less than 1 kΩ-cm, its resistance causes high-frequency loss, which increases power consumption and generates heat, degrading device characteristics.

Ion implantation limited to hydrogen and/or helium (He) ion species that have little effect on the electrical resistance of the single crystal substrate is performed on the Si<111> seed crystal, and then the ion-implanted surface of the Si<111> seed crystal is bonded to the top surface of the planarizing layer 4 and a thin film of 0.1 to 1.5 µm is peeled off and transferred to the planarizing layer 4 using physical means such as a nail at 450°C or lower to form the seed crystal layer 2. Unlike heavy elements such as boron (B), light elements such as hydrogen and He is suitable for ion implantation into seed crystals because ion implantation causes little damage to the seed crystal and does not lower its electrical resistance. In addition, peeling and transferring at low temperatures below 450°C prevents thermal damage to the Si<111> seed crystals, which is unavoidable in the usual smart-cut method of thermal peeling and transferring at high temperatures above 700°C.

The transfer thickness of the seed crystal layer 2 is preferably between 0.1 µm and 1.5 µm, inclusive. In the ion implantation, the damage layer alone has a thickness of nearly 0.1 um, and a suitable seed crystal cannot be obtained if the thickness is less than 0.1 um. In addition, the ion implant machine requires high output ion energy for transfer thicknesses of 1.5 µm or more, and the ion implanter becomes huge in size, requiring a huge investment, which is not economical.

To be more specific, after ion implanting hydrogen and/or He into the seed crystal to a depth of 0.2 to 3.5 µm, the top surface of the aforementioned planarizing layer 4 and the ion-implanted surface of the seed crystal are bonded. Then, the seed crystal may be peeled off by gas pressure, a nail, or other physical methods at temperatures below 450°C.

The top surface of the transferred thin film may then be CMP polished and/or lightly etched with chemicals to remove the ion implantation damage layer to obtain a seed single-crystal thin film (seed crystal layer 2) with a thickness of 0.1 to 1.5 um. If higher uniformity is required for ion implantation, SiO₂, etc., can be deposited on the ion implantation surface of the seed substrate before ion implantation, if necessary.

In the present invention, a stress-adjusting layer 5 may be further added to the bottom surface of the support substrate 3, if necessary. For the stress-adjusting layer 5, film material and thickness with a thermal expansion coefficient that enables correction of warpage of the seed substrate 1 caused by forming the planarizing layer 4 are selected. Generally, it is suitable to deposit at least polycrystalline Si (p-Si) as the stress-adjusting layer 5, which is also compatible with the electrostatic chuck. SiO₂ and/or silicon oxynitride (SiₓO_{y}N_{z}) or the like as a part of the stress reduction layer may be interposed between the polycrystalline Si and the encapsulating layer from the viewpoint of warpage correction and affinity with the encapsulating layer 32.

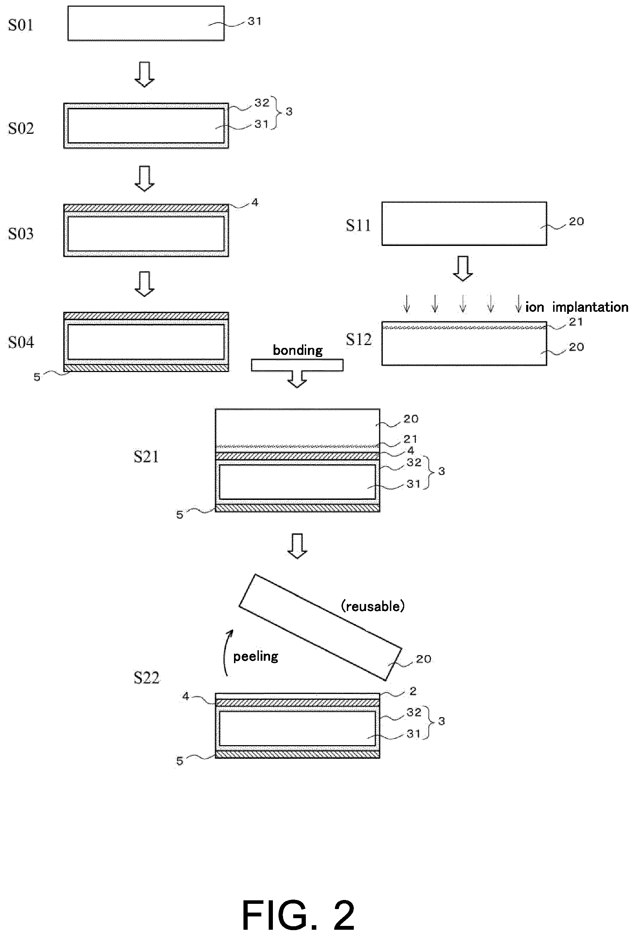

Then, with reference to FIG. 2, the procedure for the manufacturing method of the seed substrate for group III nitride epitaxial growth according to the embodiment of the present invention will be described. If a suitable method for forming each layer has already been described in conjunction with the composition of each part of the seed substrate 1, a redundant explanation here is omitted.

First, the core 31 consisting of nitride ceramics is prepared (S01 in FIG. 2). The surface voids of this core nitride ceramics are then filled by Al or Si oxide, nitride, oxynitride, or a mixture of these materials and flattened. More specifically, silicone compounds and/or silicone compounds with at least one of SiO₂, Si₃N₄, or AlN powder are applied to the surface of polycrystalline ceramics and then treated in an N₂ atmosphere to fill surface voids and flatten them before use as a core 31. Next, the encapsulating layer 32 with a thickness of between 0.05 µm and 1.5 um, inclusive, is deposited so as to wrap in the core 31 and the support substrate 3 is obtained (S02 in FIG. 2). The encapsulating layer 32 may be deposited by the LPCVD method and may contain at least a layer of Si₃N₄, with SiO₂, silicon oxynitride (SiₓO_{y}Nz), etc. added if necessary. Next, the planarizing layer 4 with a thickness of between 0.5 um and 3.0 um, inclusive, is deposited on the upper surface of the support substrate 3 (S03 in FIG. 2). If necessary, the stress-adjusting layer 5 is deposited on the bottom surface of the support substrate 3 (S04 in FIG. 2). The planarizing layer 4 and the stress-adjusting layer 5 may be deposited at the same time.

Apart from S01-S04, a Si <111> single-crystal substrate 20, which is a seed crystal for peeling transfer of the seed crystal layer 2, is prepared (S11 in FIG. 2) . Next, ion implantation is performed from one surface (ion implantation surface) of the single crystal substrate 20, and a peeling position (embrittlement layer) 21 is formed in the single crystal substrate 20 (S12 in FIG. 2).

Next, the ion implantation surface of the single crystal substrate 20 is bonded to the planarizing layer 4 formed on the support substrate 3 to obtain a bonded substrate (S21 in FIG. 2). Then, the single crystal substrate 20 is separated at the peeling position 21 of the single crystal substrate 20 in the bonded substrate (S22 in FIG. 2). In this way, a single-crystal film of Si <111> is thinly transferred as a seed crystal layer 2 onto the planarizing layer 4 on the support substrate 3. On the other hand, the remaining section of the separated Si <111> single crystal substrate 20 can be repeatedly utilized for transferring a seed crystal layer when fabricating another group III nitride composite substrate by polishing the surface again to make an ion implantation surface.

The above describes the configuration and manufacturing method of the seed substrate 1 for epitaxial growth. The present invention is mainly based on the following findings: (1) Surface voids in the polycrystalline ceramic substrate as the core affect the ceramic substrate and seed crystal layer, causing many defects to occur near the void areas; (2) The original characteristics of the seed crystal Si<111> affect the epitaxial film formation, and to reduce crystal defects, the oxidation-induced stacking fault (OSF) of the seed crystal Si<111> should be 10 defects/cm² or less; (3) There are optimal film quality and thickness for each of the encapsulating layer, planarizing layer, and seed crystal layers, and the selection of these is important; (4) Thermal stress can be balanced in the stress-adjusting layer. The present invention can utilize the synergistic effects of (1) to (4) above or a combination of them. The present invention makes it possible to economically obtain seed substrates for epitaxial growth with very little warpage, voids, and crystal defects, and furthermore, epitaxial substrates and solid substrates with very little high-frequency loss in devices.

The substrate, according to the present invention, can significantly improve the characteristics of devices, such as light-emitting diodes used in the deep ultraviolet region (UVC; 200-280 nm), high-frequency devices for 5G communications and EV vehicles, and high-voltage devices, while also significantly improving device manufacturing yields.

### EXAMPLES

The present invention will be described more specifically hereinafter by citing examples and comparative examples below, but the present invention is not limited to these examples.

### [Example 1]

### (Preparation of Support Substrate)

A support substrate 3 with a polycrystalline ceramic core 31 covered with an encapsulating layer 32 was prepared. A commercially available AlN substrate was used for the polycrystalline ceramic core 31. For this AlN substrate, a core substrate of 8 inches in diameter and 725 µm in thickness was prepared by mixing AlN powder; 100wt%, and Y₂O₃; 5wt%, as a sintering aid, with organic binders and solvents to make a green sheet, then degreasing, then sintering at 1900°C under N₂ atmosphere, and CMP polishing both sides.

Note that there were 1,500 voids with a depth of 3 um or more on the surface of this substrate, which were difficult to fill with the planarizing layer. The entire surface of the AlN ceramic substrate was coated with a mixture of alkoxysilane condensate and silica, Shin-Etsu Chemical's X-12-2220BC-3 solution (a composition consisting mainly of methyl trimethoxysilane hydrolysis condensate, colloidal silica, and isopropanol with a solid content of 20%), after drying, the substrate was treated in an N₂ atmosphere at 1000°C to fill voids on the substrate surface, and then the surface was lightly CMP polished and flattened. The encapsulating layer 32 was formed by covering this entire AlN ceramic core 31 with a 0.1-µm-thick silicon oxynitride layer by LPCVD, and then encapsulating the entire core with a 0.4-pm-thick Si₃N₄ layer using another LPCVD apparatus. The total thickness of the encapsulating layer 32 was 0.5 µm. For the purpose of planarization, a 6 um thick SiO₂ was further stacked on the Si₃N₄ layer only on one side by using the plasma CVD (ICP-CVD apparatus). Then, after baking at 1000°C, the SiO₂ was planarized by CMP polishing to a thickness of 2 um (Ra = 0.2 nm) in preparation for thin film transfer of the seed crystal.

### (Preparation of Seed Crystal)

A Si <111> single-crystal substrate of 8 inches in diameter and 725 um in thickness was prepared as the seed crystal substrate. This Si<111> single-crystal substrate had oxidation-induced stacking faults (OSF) of 9 defects/cm² and an electrical resistivity (room temperature) of 1.3 kΩ-cm by the evaluation method described in Patent Document 3. Ion implantation of hydrogen was carried out on the Si substrate at 100 keV, at a depth of 0.6um, and with a dose of 9 × 10¹⁶ cm⁻².

A 0.6 µm portion of the surface layer of this ion-implanted Si <111> single crystal was thinly transferred to the planarizing layer 4 (2 um thickness) of the previously prepared support substrate 3. The section of the Si <111> single crystal, which was damaged during ion implantation and transfer, was lightly polished with CMP, and the thickness of the Si <111> single crystal layer was reduced to 0.4 um, which was used as seed crystal layer 2. The resulting seed substrate 1 was free of cracks, delamination, and warpage as a result of ensuring that the film thicknesses were balanced with respect to the thermal stresses between each layer of the encapsulating layer 32, the encapsulating layer 32, the planarizing layer 4, and the seed crystal layer 2.

The remaining Si<111> single-crystal substrate after thin-film transfer could be used repeatedly as many seed crystals by repeated ion implantation, which was extremely economical.

A seed substrate 1 with a 2 µm-thick planarizing layer 4 and a 0.4 µm-thick Si <111> single-crystal seed crystal layer 2 on a support substrate 3 with an AlN ceramic core 31 and encapsulating layer 32 was obtained. The following brief evaluation of the characteristics of this seed substrate 1 as a seed substrate for epitaxial growth of GaN was performed.

The above seed substrate 1 was placed in the reactor of the MOCVD apparatus and epitaxial growth was performed. In this process, the epitaxial layers were deposited in the order of AlN and AlGaN from the seed substrate 1 side toward the growth direction, followed by the epitaxial growth of GaN. In this evaluation, 100 nm of the AlN layer and 150 nm of the AlGaN layer were formed. The total thickness of the epitaxial layer was 10 um. During epitaxial growth, TMAl (trimethylaluminum) was used as the Al source, TMGa (trimethylgallium) was used as the Ga source, and NH3 was used as the N source. The carrier gas was N₂ with 10% H₂, and the process temperature was 1100°C.

Then, to evaluate dislocation density, etch pits were generated by a molten alkali (KOH) etching method, and etch pit density (EPD) was measured. In addition, X-ray rocking curve (XRC) measurements were performed to evaluate the crystallinity.

As a result, the EPD showed an extremely low dislocation density of 0.1 × 10⁴ cm⁻². The XRC measurements on a (0002) plane of the substrate yielded a half-value width FWHM (hereafter simply referred to as "FWHM of 0002XRC") of 105 arcsec, resulting in a high-quality GaN single crystal. These results show that the seed substrate 1 in this example has excellent characteristics as a seed substrate for epitaxial growth. When this epitaxial substrate with an epitaxial layer on the seed substrate 1 was used for a 30 GHz/20 Gbps high-frequency device, the surface temperature of the device was 39°C, and the temperature increase due to high-frequency loss was small.

### [Comparative Example 1]

The same conditions as in Example 1 were used for all processes up to epitaxial deposition, except that the surface voids of the AlN ceramic substrate were not filled and flattened and were used as the core substrate as is, and then the same evaluations were conducted. As a result, crystal defects were observed in the epitaxially deposited film at locations corresponding to voids with sizes similar to those of the voids, and device failures were also frequently observed in these areas. The EPD showed a dislocation density of 211 × 10⁴ cm⁻². The XRC measurements on a (0002) plane of the substrate yielded a half-value width FWHM (hereafter simply referred to as "FWHM of 0002XRC") of 863 arcsec, resulting in a GaN single crystal with poor crystal properties. These results show that the seed substrate for epitaxial growth of seed substrate 1 in this example, which includes the portion with voids, had many epitaxial defects. This was a cause of yield loss in the subsequent production of devices. When the device of the part of the epitaxial substrate without voids was used for high-frequency devices at 30 GHz/20 Gbps, the surface temperature of the device was 39°C, and the temperature increase due to high-frequency loss was small. However, the portion of the epitaxial substrate with voids was difficult to make into devices and caused a decrease in device yield.

### [Example 2]

### (Preparation of Support Substrate)

A commercially available AlN substrate, as in Example 1, was used for the polycrystalline ceramic core 31. Note that there were 2,500 voids of 3 µm or more in depth on the surface of the substrate in this example, which were difficult to fill with the planarizing layer. The entire surface of the AlN ceramic substrate was treated with a silicone compound made by Shin-Etsu Chemical KBM-3103 or X-12-641 with 5% AlN powder, which was adjusted, applied, dried, and treated in an N₂ atmosphere at 1500°C. The surface of the AlN powder was then modified by SiN, thereby filling the voids on the substrate surface, and then the void areas on the surface were flattened by CMP polishing. The flattened AlN ceramic core 31 was first entirely encapsulated with a 0.3-pm-thick SiO₂ layer by LPCVD, and then entirely encapsulated with a 0.8-um-thick Si₃N₄ layer using another LPCVD apparatus to form the encapsulating layer 32. The total thickness of the encapsulating layer 32 was 1.1 µm. For further planarization, 5 µm of silicon oxynitride was stacked on this Si₃N₄ layer by LPCVD only on the upper layer of the encapsulating layer 32. After that, the silicon oxynitride layer was CMP polished to a thickness of 2.5 µm. At this stage, the entire substrate warped significantly, approximately 30 µm. To correct the warpage, a 5 µm-thick of SiO₂ and a 0.2 µm-thick of non-doped polycrystalline Si layer, which also serves as an electrostatic chuck layer, were deposited as the stress-adjusting layer 5 on the bottom surface by plasma CVD. As a result, the warpage was eliminated, and the chuck could be used as an electrostatic chuck with sufficient absorption and desorption.

### (Preparation of Seed Crystal)

A Si <111> single-crystal substrate of 8 inches in diameter and 725 um in thickness was prepared as the seed crystal substrate. This Si<111> single-crystal substrate had oxidation-induced stacking faults (OSF) of 0 defects/cm² and an electrical resistivity (room temperature) of 2.3 kΩ-cm by the evaluation method described in Patent Document 3. Ion implantation of hydrogen was carried out on the Si substrate at 130 keV, at a depth of 1.4µm, and with a dose of 9.5 × 10¹⁶ cm⁻².

A 1.4 µm portion of the surface layer of this ion-implanted Si <111> single crystal was thinly transferred to the planarizing layer 32 (2.5 um thickness) of the previously prepared support substrate 3. The section of the Si <111> single crystal, which was damaged during ion implantation and transfer, was lightly polished with CMP, and the thickness of the Si <111> single crystal layer was reduced to 1 um, which was used as seed crystal layer 2. The resulting seed substrate 1 was free of cracks, delamination, and warpage as a result of ensuring that the film thicknesses were balanced with respect to the thermal stresses between each layer of the encapsulating layer 32, the encapsulating layer 32, the planarizing layer 4, and the seed crystal layer 2.

As in Example 1, the remaining Si<111> single-crystal substrate after thin-film transfer could be used repeatedly as many seed crystals by repeated ion implantation, which was extremely economical.

A seed substrate 1 with a 2.5 µm-thick planarizing layer 4 and a 1 µm-thick Si <111> single-crystal seed crystal layer 2 on a support substrate 3 with an AlN ceramic core 31 and encapsulating layer 32 was obtained. A thick single-crystal substrate of AlN was prepared using this substrate 1 as follows.

A 600 µm single crystal of AlN was deposited on this seed substrate 1 by THVPE using AlCl₃ and NH₃ as raw materials. The deposited thick AlN single crystals were cut into pieces with a wire saw and polished to make smooth 8-inch diameter AlN single crystal substrates. The cut AlN single-crystal substrates had no coloration, and the transmittance of light at a wavelength of 220 nm was about 80%, with a film thickness of 100 um. Then, a brief evaluation was conducted using this substrate as a seed substrate for epitaxial growth of AlN.

2 µm AlN was deposited on the substrate by MOCVD, and as in the evaluation in Example 1, etch pits were generated by the molten alkali (KOH) etching method to evaluate dislocation density, and EPD was measured. In addition, X-ray rocking curve (XRC) measurements were performed to evaluate the crystallinity.

As a result, the EPD showed an extremely low dislocation density of 0.4 × 10⁴ cm⁻². In addition, the FWHM of the 0002 XRC was 100 arcsec, resulting in a high-quality AlN single crystal. This AlN single-crystal substrate has very few defects as an LED substrate for the deep-ultraviolet region, has high device characteristics, and is an economically superior substrate with no yield loss due to voids.

### [Comparative Example 2]

A single-crystal Si <111> substrate of 8 inches in diameter with oxidation-induced stacking faults (OSF) of 18 defects/cm² and an electrical resistivity (room temperature) of 0.5 kΩ-cm was used as the seed substrate, and a seed crystal layer 2 with a thickness of 1.3 um was thinly transferred. Other than that, seed substrate 1 was fabricated under the same conditions as in Example 1. In the same way as in Example 1, 5 µm of GaN was deposited on this seed substrate 1 by MOCVD. As a result, the EPD showed an extremely large dislocation density of 65 × 10⁴ cm⁻². In addition, the FWHM of the 0002 XRC was 780 arcsec, resulting in a GaN single crystal with poor crystallinity compared to Example 1. When this epitaxial substrate was used for 30 GHz/20 Gbps high-frequency devices, the surface temperature of the device reached as high as 130°C due to high-frequency loss. Thus, long-term use was not possible.

### [Example 3]

The planarization layer 4 was a two-layer SiO₂/AlAs structure with a total thickness of 2.8 µm, consisting of a 2-µm-thick AlAs bottom layer and a 0.8-um-thick SiO₂ top layer. Other than that, seed substrate 1 for epitaxial growth was obtained under the same conditions as in Example 1.

The remaining Si<111> single-crystal substrate after thin-film transfer could be used repeatedly as many seed crystals by repeated ion implantation, which was extremely economical.

A seed substrate 1 with a support substrate 3 having a structure of AlN ceramic core 31 and encapsulating layer 32, a composite planarizing layer 4 of SiO₂/AlAs with a total thickness of 2.8 µm, and a 0.9 um thick Si <111> single crystal seed crystal layer 2 thereon was obtained. Using this seed substrate 1 as a seed substrate for the epitaxial growth of GaN, a thick film of GaN was epitaxially grown.

After depositing a 180 µm GaN film on the above seed substrate 1 by MOCVD, the planarizing layer 4 of SiO₂/AlAs was dissolved in HF solution to obtain a solid GaN substrate with an approximate thickness of 180 µm.

To evaluate the dislocation density of this solid GaN substrate, etch pits were generated by the molten alkali (KOH) etching method, and EPD was measured, as in the evaluation in Example 1. In addition, X-ray rocking curve (XRC) measurements were performed to evaluate the crystallinity.

As a result, the EPD showed an extremely low dislocation density of 0.1 × 10⁴ cm⁻². In addition, the FWHM of the 0002 XRC was 130 arcsec, resulting in a high-quality GaN single crystal. These figures show that the seed substrate 1 in this example is extremely excellent as a seed substrate for epitaxial growth to obtain a solid substrate. The solid GaN substrate obtained by epitaxial growth using this seed substrate 1 was used for high-frequency devices at 30 GHz/20 Gbps. The surface temperature of the device was 40°C, indicating that the substrate was excellent with low heat generation due to high-frequency loss.

### REFERENCE SIGNS LIST

1 Seed substrate
2 Seed crystal layer
3 Support substrate
4 Planarizing layer
5 Stress-adjusting layer
20 Single crystal substrate of seed crystal
21 Peeling position

## Claims

1. A seed substrate for epitaxial growth comprising:
a support substrate;
a planarizing layer provided on an upper surface of the support substrate, the planarizing layer having a thickness of between 0.5 um and 3.0 um, inclusive; and
a seed crystal layer provided on an upper surface planarizing layer,
wherein the support substrate comprises:
a core of polycrystalline ceramics with surface voids filled and flattened by Al or Si oxide, nitride, oxynitride, or a mixture of these; and
an encapsulating layer that encapsulates the core, the encapsulating layer having a thickness of between 0.05 µm and 1.5 um, inclusive, and
the seed crystal layer is provided by thin-film transfer of 0.1 to 1.5 µm of surface layer of Si <111> single crystal.

2. The seed substrate for epitaxial growth as claimed in claim 1, wherein the surface voids of the polycrystalline ceramics are filled and flattened by applying a silicone compound and/or a silicone compound with at least SiO₂, Si₃N₄, or AlN powder to the surface of the polycrystalline ceramics, followed by treatment in an N₂ atmosphere.

3. The seed substrate for epitaxial growth as claimed in claim 1 or 2, wherein the silicone compound is alkoxysilane and/or condensate thereof.

4. The seed substrate for epitaxial growth as claimed in any one of claims 1 to 3, wherein the group III nitride polycrystalline ceramics forming the core are AlN ceramics.

5. The seed substrate for epitaxial growth as claimed in any one of claims 1 to 4, wherein the encapsulating layer includes at least a layer of Si₃N₄.

6. The seed substrate for epitaxial growth as claimed in any one of claims 1 to 5, wherein the planarizing layer comprises SiO₂ and/or silicon oxynitride (SiₓO_{y}N_{z}) or AlAs.

7. The seed substrate for epitaxial growth as claimed in any one of claims 1 to 6, wherein the seed crystal layer is Si <111> with oxidation-induced stacking faults of 10 defects/cm² or less

8. The seed substrate for epitaxial growth, as claimed in any one of claims 1 to 7, further comprises a stress-adjusting layer made of a semiconducting compound such as polycrystalline Si on the bottom surface of the support substrate.

9. The seed substrate for epitaxial growth as claimed in any one of claims 1 to 8, wherein the stress-adjusting layer is polycrystalline Si with SiO₂ and/or silicon oxynitride (SiₓO_{y}N_{z}) interposing just below the bottom surface of the support substrate.

10. A semiconductor substrate on which a III-V semiconductor thin film is deposited on the top surface of the seed substrate for epitaxial growth according to any one of claims 1 to 9.

11. The semiconductor substrate, as claimed in claim 10, wherein the III-V semiconductor thin film is a nitride semiconductor thin film containing Ga and/or Al.

12. A manufacturing method of seed substrate for epitaxial growth comprising steps of:
preparing a core consisting of group III nitride polycrystalline ceramics with surface voids filled by Al or Si oxide, nitride, oxynitride, or a mixture of these materials and flattened;
obtaining a support substrate by depositing an encapsulating layer so as to wrap the core, the encapsulating layer having a thickness of between 0.05 µm and 1.5 µm, inclusive;
depositing a planarizing layer on an upper surface of the support substrate, the planarizing layer having a thickness of between 0.5 um and 3.0 µm, inclusive; and
providing a seed crystal layer by thin-film transfer of 0.1 to 1.5 um of the surface layer of Si <111> single crystal on the top surface of the planarizing layer.

13. The manufacturing method of seed substrate for epitaxial growth as claimed in claim 12, wherein the encapsulating layer is deposited by the LPCVD.

14. The manufacturing method of seed substrate for epitaxial growth as claimed in claim 12 or 13, wherein the planarizing layer is formed by depositing SiO2 and/or silicon oxynitride (SixOyNz) or AlAs on one or all sides of the support substrate by one of plasma CVD, LPCVD, and low-pressure MOCVD.

15. The manufacturing method of seed substrate for epitaxial growth as claimed in any one of claims 12 to 14, wherein in the step of providing the seed crystal layer, the seed crystal layer is provided by ion implanting hydrogen and/or He into Si <111> single crystal with oxidation-induced stacking faults of 10 defects/cm² or less, followed by transferring a thin film of the Si <111> single crystal of 0.1 to 1.5 µm by physical means at 450°C or less.

16. The manufacturing method of seed substrate for epitaxial growth as claimed in any one of claims 12 to 15, further provides a stress-adjusting layer on the bottom surface of the support substrate.

17. The manufacturing method of seed substrate for epitaxial growth as claimed in claim 16, wherein the stress-adjusting layer consists of polycrystalline Si made by a method selected from at least sputtering, plasma CVD, and LPCVD that can further correct the warpage after the planarizing layer is provided.

18. A manufacturing method of semiconductor substrate comprising steps of:
manufacturing a seed substrate for epitaxial growth by the manufacturing method of seed substrate for epitaxial growth as claimed in any one of claims 12 to 17; and
depositing a III-V semiconductor thin film on the top surface of the seed substrate for epitaxial growth.
